# EUROPEAN PATENT SPECIFICATION

(11) **EP 0 916 688 B1**
(45) Date of publication and mention of the grant of the patent: **26.01.2005**
(21) Application number: 98120853.1
(22) Date of filing: 03.11.1998
(51) Int. Cl.: C08G 73/06, C08G 59/40, C08G 59/08, C08L 79/04, C08L 63/00, H01L 23/29

(54) **Polyfunctional cyanate resin composition and resin-encapsulated type semiconductor device**
Polyfunktionelle Cyanatharzzusammensetzung und eine damit verkapselte Halbleiteranordnung
Composition de résine cyanate polyfonctionnelle et dispositif de semi-conducteur encapsulé par cette résine

(30) Priority: 11.11.1997 JP 30879297
(43) Date of publication of application: 19.05.1999
(73) Proprietor: Sumitomo Chemical Company, Limited, Tokyo 104-8260 (JP)
(72) Inventor: Hayashi, Toshiaki, Tsukuba-shi, Ibaraki (JP); Nakajima, Nobuyuki, Tsukuba-shi, Ibaraki (JP)
(74) Representative: Henkel, Feiler & Hänzel

(56) References cited:
- EP-A- 0 298 742
- EP-A- 0 516 273
- EP-A- 0 739 879
- EP-A- 0 811 619
- WO-A-96/17020
- US-A- 5 132 778
- PATENT ABSTRACTS OF JAPAN vol. 097, no. 008, 29 August 1997 & JP 09 100393 A (SHIN ETSU CHEM CO LTD), 15 April 1997
- PATENT ABSTRACTS OF JAPAN vol. 013, no. 182 (C-591), 27 April 1989 & JP 01 011125 A (HITACHI LTD), 13 January 1989
- PATENT ABSTRACTS OF JAPAN vol. 097, no. 006, 30 June 1997 & JP 09 052941 A (SHIN ETSU CHEM CO LTD), 25 February 1997
- DATABASE WPI Section Ch, Week 8822 Derwent Publications Ltd., London, GB; Class A21, AN 88-150575 XP002092580 & JP 63 090531 A (SUMITOMO BAKELITE CO) , 21 April 1988
- PATENT ABSTRACTS OF JAPAN vol. 018, no. 443 (C-1239), 18 August 1994 & JP 06 136096 A (SUMITOMO BAKELITE CO LTD), 17 May 1994

## Description

### BACKGROUND OF THE INVENTION

### Technical Field of the Invention

The present invention relates to a cyanate resin composition which is useful as an adhesive, a coating material, electric and electronic materials such as insulation materials and laminated plates, especially for the encapsulating an electronic device, and a resin-encapsulated type semiconductor device using the same.

### Description of the Related Art

In recent years, for electronic instruments, characteristics such as small size, light weight, excellent performance and high speed are still required. In connection with this, a semiconductor package which is yet smaller and suitable for high-density mounting has become necessary. Due to such requirements, various forms of semiconductor packages are proposed. Among them, BGA (Ball Grid Array) packages with its easy formation of large number of pins and its easy mounting, have attracted much attention, and have thus been widely studied.

About the encapsulating resin for this BGA, there has been a problem in that warpage arises from the mismatch of the thermal expansion coefficients between an encapsulating resin and a substrate. As a means to solve this problem, resins having a high heat resistant property and a low thermal expansion coefficient have been required, and a development focusing on an epoxy resin has been conducted. However, there is a limit in the performance of an epoxy resin, and a fully satisfactory resin has not been obtained.

On the one hand, it is known that a polyfunctional cyanate resin has an excellent high heat resistant property and a low thermal expansion property, and it is also hitherto known that the resin is used for an encapsulating material in combination with an epoxy resin (U.S. patent No. 5132778).
However, when combining with an epoxy resin of a low melting point or softening point, the softening point of a cyanate resin composition becomes low, the blocking resistance of the resin compounds falls remarkably and the resin compounds themselves become easy to adhere, thus there has been a big problem in preservation stability.

EP-A-0 811 619, which has to be regarded as a prior-art document according to Article 54(3) and (4) EPC, discloses an ester compound prepared by esterifying at least one OH group of a polyhydric phenol as a condensation product of a non-substituted or substituted resorcinol and a carbonyl compound with an organic carboxylic acid having 1 to 20 carbon atoms or a derivative thereof, which necessarily contain an organic carboxylic polyacid having 1 to 20 carbon atoms or a derivative thereof. The ester compound can be used as an epoxy resin curing agent affording a cured article having low dielectric constant, low moisture absorption and sufficient heat resistance.

WO-A-96/17020 discloses a curable resin blend including a multifunctional phenolic cyanate/phenolic triazine copolymer, and an epoxy resin, and articles manufactured therefrom.

EP-A-0 516 273 discloses a thermal resistance resin dust obtained by a process which comprises a step of preparing a composition comprising (I) an aromatic hydrocarbon resin-modified novolak type epoxy resin and (II) a cyanate ester resin composition comprising (a) polyfunctional cyanate esters, prepolymers of said cyanate ester, or prepolymers of said cyanate ester and an amine; or (a) in combination with (b) a monofunctional or polyfunctional maleimide, a prepolymer of said maleimide or a prepolymer of said maleimide and an amine, and optionally (III) an inorganic filler with cleavage property, a step of curing the composition at a final curing temperature of not less than 200°C and a step of grinding the cured product.

EP-A-0 298 742 discloses urea compounds having a plurality of substituents selected from hydrogen, substituted hydrocarbyl radicals and unsubstituted hydrocarbyl radicals which are good latent cure accelerators for thermosetting cyanate resin formulations.

JP-A-09100393 discloses a thermosetting resin composition excellent in setting properties, adhesion of set products, stress properties, etc., by using as a resin component a combination of a specified cyanate ester compound (prepolymer) and an epoxy resin.

JP-A-01011125 discloses a resin composition comprising (A) a polyfunctional expoxy compound prepared by reaction between novolak type phenolic resin and epichlorohydrin in the presence of an alkali, (B) a fluorine-containing cyanate polymer constituted of sructural units, respectively, of formulae II (X, is H, CH₃, etc.) and III (X₃ is the same kind as X₁), derived from reaction, in the presence of e.g. triethylamine, between molten novolak type phenolic resin, a compound of formula I (R is F or CF₃, C₂F₅ etc.) and another compound of formula BrC=N and/or (C) a second fluorine-containing cyanate polymer constituted of structural units, respectively, of formulae IV and V, derived from reaction between p-hydroxystyrene and the compounds, respectively, of the formulae IV and V.

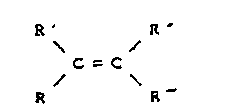

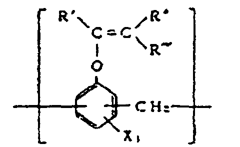

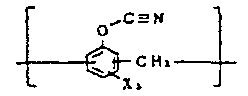

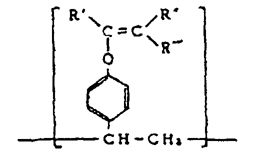

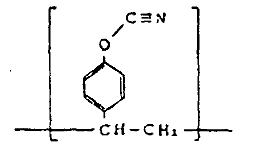

### SUMMARY OF THE INVENTION

The object of the present invention is to provide a composition, which has a high heat resistant property, a low thermal expansion coefficient, and an excellent blocking resistance of a resin compound, and a resin-encapsulated type semiconductor device using the same.

In view of such a situation, the present inventors have made extensive studies, and found that the above problem can be solved by combining a cyanate resin and/or its prepolymer with a specific epoxy resin, and thus, completed the invention.

That is, the present invention is as follows.
(1) A polyfunctional cyanate resin composition comprising (A) a polyfunctional cyanate resin having a functional number of 2 or more or its prepolymer, (B) an epoxy resin having a softening point or melting point of 75°C or more, and (C) a curing catalyst as indispensable components, characterized in that the epoxy resin is an epoxy resin represented by the following general formula (1), 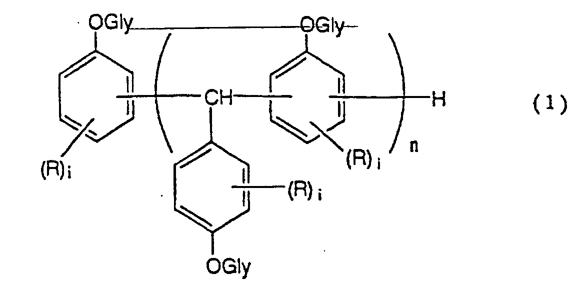 in the formula, n represents an average repeating number of 0-10; R represents each independently either hydrogen atom, an alkyl group having 1 to 10 carbon atoms, a cycloalkyl group having 5 to 7 carbon atoms or a hydrocarbon group having 6 to 20 carbon atoms containing a cycloalkyl group having 5 to 7 carbon atoms; the symbol i is each independently an integer of 1-4; when i is two or more, R may be the same, or may differ from each other; and Gly represents glycidyl group.
(2) The polyfunctional cyanate resin composition comprising the polyfunctional cyanate resin composition described in (1), and (D) an inorganic filler as indispensable components.
(3) The polyfunctional cyanate resin composition described in (1) or (2), wherein the polyfunctional cyanate resin is a cyanate resin derived from bisphenol A.
(4) A resin-encapsulated type semiconductor device, wherein a semiconductor element is encapsulated using the polyfunctional cyanate resin composition described in (1), (2) or (3).

### DETAILED DESCRIPTION OF THE INVENTION

The polyfunctional cyanate resin having a functional number of 2 or more which is a component (A) used in the present invention can be obtained by conducting a dehydrohalogenation reaction of a phenol as a raw material with a cyanogen halide such as cyanogen chloride and cyanogen bromide in a suitable organic solvent.

Examples of a polyfunctional cyanate resin include bifunctional cyanate resins, such as 2,2-bis(4-cyanatephenyl)propane, bis(4-cyanatephenyl)ethane, bis(4-cyanate-3,5-dimethylphenyl)methane, 1,3-bis(4-cyanatephenyl-1-(methyl ethylidene))benzene, bis(4-cyanatephenyl)thioether, bis(4-cyanatephenyl)ether; and polyfunctional cyanate resins derived from, such as phenol novolak and cresol novolak.

The polyfunctional cyanate resin which is a component(A) used in the present invention can be employed appropriately according to requirements. In order to attain the object of the present invention, especially a cyanate resin derived from bisphenol A is suitable from the point of reactivity and heat-resistance.

The polyfunctional cyanate resin used in the present invention may be used as a monomer, and may be also used as a prepolymer.

The prepolymer can be obtained by heating a cyanate resin at 50 - 200°C in a solvent or in bulk as alone or as a mixture of two or more. It can be also obtained by heating to 50 - 200°C in a solvent or in bulk with the curing catalyst which is the below-mentioned component(C).

The epoxy resin having a softening point or melting point of 75 °C or more which is the component (B) used in the present invention is selected from the epoxy resins represented by the above general formula (1), without being limited thereto.

Examples of the alkyl group having 1 to 10 carbon atoms of R in the above general formula (1) include, methyl group, ethyl group, propyl group, butyl group, hexyl group, nonyl groups, or isomers thereof. Example of the cycloalkyl group having 5 to 7 carbon atoms include cyclopentyl group, cyclohexyl group, etc. Furthermore, examples of the hydrocarbon group having 6 to 20 carbon atoms containing cycloalkyl group having 5 to 7 carbon atoms include benzyl group, phenetyl group, styryl group, mesityl group, etc., without being limited thereto.

The polyfunctional cyanate resin and the epoxy resin having a softening point or melting point of 75 °C or more which are used in the present invention can be formulated in appropriate compounding ratios. In order to attain the object, the formulation amount of the polyfunctional cyanate resin is suitably 20% - 90%, more suitably 30% - 70%. When the formulation amount of a polyfunctional cyanate resin becomes low, the heat resistance of a cured product will fall. When the formulation amount becomes high, the blocking resistance of a resin compound will fall.

The curing catalyst which is the component(C) used in the present invention is a curing catalyst for a cyanate resin, and known catalysts can be used. Examples are, proton acids represented by hydrochloric acid and phosphoric acid; Lewis acids represented by aluminum chloride, a boron trifluoride complex, and zinc chloride; aromatic hydroxy compounds represented by phenol, pyrocatechol, and dihydroxy naphthalene; metal organic salts such as zinc naphthenate, cobalt naphthenate, tin octylate, cobalt octylate, etc.; metal organic complexes such as copper acetylacetonate, aluminum acetylacetonate, etc.; tertiary amines such as triethyl amine, tributyl amine, quinoline, isoquinoline, diazabicyclo[2, 2, 2]octane, etc.; quarternary ammonium salts represented by tetraethylammonium chloride and tetraethylammonium bromide; imidazoles; and sodium hydroxide, sodium methylate, triphenyl phosphine, or these mixtures.

Among these curing catalysts, metal organic salts such as zinc naphthenate, cobalt octylate and tin octylate, metal organic complexes such as copper acetylacetonate, imidazoles, phenols, or these mixed catalysts are suitably exemplified. The curing catalyst used in the present invention can be used in appropriate amount. As for encapsulating use, it is usually formulated so that the gel time of a composition becomes 10 seconds - 10 minutes at a setting temperature of 100°C - 250°C.

Examples of the inorganic filler which is the component(D) used in the present invention include silica, alumina, titanium white, aluminum hydroxide, talc, clay, glass fiber, etc., and silica and alumina are preferable. These can be used as a mixture of those having various forms (spherical or crushed) or various sizes, and can be also used with increasing the filling amount.

The filling amount of the inorganic filler is 25-92 % by weight in the whole resin composition, and suitably 70-90 % by weight. When the amount is little, a problem will occur in moisture absorption characteristics, such as the solder heat resistance after moisture absorption, or the volume resistivity after moisture absorption. Moreover, when exceeding 92%, a problem in moldability will occur.

In the resin composition of the present invention, a mold lubricant such as a natural wax, a synthetic wax, a higher fatty acid and its metal salts, and a paraffin; or a colorant like carbon black; a surface treatment agent like a silane coupling agent etc. further may be added according to requirements. Moreover, flame retardants, such as antimony trioxide, a phosphorous compound, and a brominated epoxy resin, may be added.

In order to lower the stress, various elastomers can be added, optionally with having reacted beforehand. Examples of the elastomers include polybutadiene, butadiene-acrylonitrile copolymer, silicone rubber, and silicone oil, or a reactive type elastomer.

In order to encapsulate an electronic device such as a semiconductor and to produce a resin-encapsulated type semiconductor device with using the resin composition of the present invention, cure molding can be carried out by a well-known molding method such as transfer molding, compression molding, or injection molding.

In the resin composition of the present invention, other thermosetting resins can be used together within the range which does not injure the purpose. For example, bismaleimides, the addition polymerization products of bismaleimide with diamine; alkenylaryl ether or amine resins such as a bisvinylbenzylether compound of bisphenol A, and vinylbenzyl compounds of diaminodiphenylmethane; alkynylether or amine resins such as a dipropargylether of bisphenol A, and a dipropargyl compound of diaminodiphenylmethane. In addition to these, phenol resins, resol resins, allylether type compounds, allylamine type compounds, isocyanates, triallylisocyanurates, triallylcyanurates, vinyl group containing polyolefin compounds, etc. are exemplified. It is possible to also add a thermoplastic resin. For example, polyphenylene ether, polystyrene, polyethylene, polybutadiene, polyimides, polycarbonates, polyacrylates, poly methacrylates, and modifications thereof are exemplified. These resins can be mixed in the cyanate resin composition, and also can be used with having reacted beforehand.

### EXAMPLES

Examples of the present invention are shown below, but the present invention cannot be limited to these.

### Synthetic Example 1

This example is a synthetic example of a cyanate resin prepolymer used in the present invention.

2,2-bis(4-cyanatephenyl)propane 2000g was charged into a 3 litter flask equipped with a thermometer and a reflux condenser. This was heated to melt in an oil bath, and after the inner temperature reached to 150°C, mechanical stirring was conducted for 15 hours and a cyanate prepolymer was obtained.

### Synthetic Example 2

This example is a synthetic example of an epoxy resin used in the present invention.

Into a reactor equipped with a thermometer, a stirrer, and a condenser having a separation tube, 2-t-butyl-5-methylphenol 328g, p-hydroxybenzaldehyde 122g, and toluene 450g were charged. Then 0.95g of p-toluenesulfonic acid (monohydrate) was charged. By azeotropically distilling toluene and water at 113-120°C under atmospheric pressure, condensation reaction was carried out for 8 hours, while returning only a toluene layer to the system. After neutralization with sodium hydroxide, toluene and the unreacted monomer were distilled off, and a polyhydric phenol was obtained.

Then, the polyhydric phenol (1 equivalent amount of phenolic hydroxy group) was charged into a reaction container equipped with a thermometer, a stirrer, a dropping funnel, and a condenser having a separation tube, and was dissolved in epichlorohydrin 462.6g and dimethyl sulfoxide 231.3g.

40% sodium hydroxide aqueous solutions 100g was added dropwise continuously for 5 hours, maintaining the reaction system at 45 Torrs. In the meantime, the cooling liquefaction of azeotropically boiled epichlorohydrin and water was carried out, with maintaining the temperature at 45°C, and returning the organic layer to the reaction system.

After the reaction, unreacted epichlorohydrin was removed by vacuum distillation. The glycidylether containing by-produced salts and dimethylsulfoxide was dissolved in methylisobutylketone, then the by-produced salt and dimethyl sulfoxide were removed by washing with water. Furthermore methylisobutylketone was removed by vacuum distillation and the desired epoxy resin was obtained. The softening point of the resultant epoxy resin was 83°C, and the average repeating number was 1.7.

### Example 1

Various compositions described in Table 1 were compounded with the formulation ratio described in the table, and heat-kneading was carried out with using a two roll mill (the temperatures of the rolls were set to 110 °C and 50 °C, respectively). Then, transfer molding was carried out at 175°C, finally after-cure was performed for 180°C x 5 hours in an oven, and a cured product was obtained. The physical properties of the resultant cured product are shown in Table 1.

Details of the components are as follows.
ESCN-195: Epoxy resin (made by Sumitomo Chemical Co.,Ltd., softening point 65°C)
PSM-4261: Phenol novolak (made by Gun-ei Chemical Industry Co., Ltd.)
SH-6040: Coupling agent (made by Toray Dow Corning)
FB-60: Spherical silica (made by Denki Kagaku Kogyo K.K.)
FS-891: Crush silica (made by Denki Kagaku Kogyo K.K.)

### Comparative Examples 1-3

Cured products were obtained as the same manner with Example 1, except that the formulation of the composition were as shown in Table 1. The physical properties of the resultant cured products are shown in Table 1.

The physical properties were measured by the following methods.
Glass Transition Temperature, and thermal expansion coefficient (α 1) : Determined from the inflection point of a thermal expansion curve using a thermal analyzer TMA120 made by Seiko Instruments Inc. α 1 is the average value from 50°Cto 100°C
Blocking Resistance : Resin compositions kneaded by a roll were kept in 40°C oven, and observed the state of the compound. ○ means that there is no blocking of the compound, and × means that blocking of the compound occurs.
Softening Point : Determined by RING&BALL method.

**Table 1**

| | Example 1 | Comparative Example 1 | Comparative Example 2 | Comparative Example 3 |
|---|---|---|---|---|
| Cyanate prepolymer | 49.61 | 49.61 | - | - |
| Epoxy resin of synthetic example 2 | 49.61 | - | 66.53 | - |
| ESCN-195 | - | 49.61 | - | 64.37 |
| PSM-4261 | - | - | 32.80 | 34.99 |
| Zinc naphthenate | 0.40 | 0.40 | - | - |
| Triphenyl phosphine | - | - | 1.00 | 0.97 |
| Carnauba wax | 1.49 | 1.49 | 1.00 | 0.97 |
| SH-6040 | 1.98 | 1.98 | 1.33 | 1.29 |
| FB-60 | 317.52 | 317.52 | 317.87 | 317.94 |
| FS-891 | 79.38 | 79.38 | 79.47 | 79.49 |
| Filler content (%) | 80 | 80 | 80 | 80 |
| Tg (TMA method) | 189 | 185 | 173 | 15.1 |
| α1 (ppm/°C) | 10.4 | 10.1 | 13.6 | 14.7 |
| Blocking resistance | ○ | × | ○ | ○ |

The polyfunctional cyanate resin composition of the present invention is excellent in a high heat resistant property or a low thermal expansion property. The blocking resistance of the resin compound is also still good. The resin-encapsulated type semiconductor device using this resin composition is useful as a BGA use for which high heat resistant property and low expansion property is required.

## Claims

1. A polyfunctional cyanate resin composition comprising (A) a polyfunctional cyanate resin having a functional number of 2 or more or its prepolymer, (B) an epoxy resin having a softening point or melting point of 75 °C or more, and (C) a curing catalyst as indispensable components, **characterized in that** the epoxy resin is an epoxy resin represented by the following general formula (1), 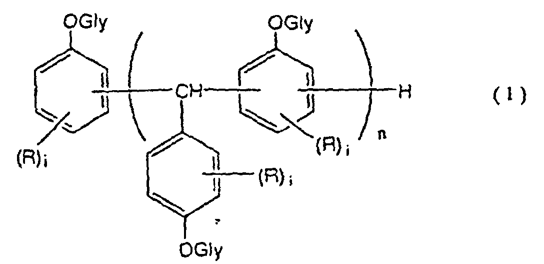 in the formula, n represents an average repeating number of 0-10; R represents each independently either hydrogen atom, an alkyl group having 1 to 10 carbon atoms, a cycloalkyl group having 5 to 7 carbon atoms or a hydrocarbon group having 6 to 20 carbon atoms containing a cycloalkyl group having 5 to 7 carbon atoms; the symbol i is each independently an integer of 1-4; when i is two or more, R may be the same, or may differ from each other; and Gly represents glycidyl group.

2. The polyfunctional cyanate resin composition comprising the polyfunctional cyanate resin composition described in claim 1, and (D) an inorganic filler as indispensable components.

3. The polyfunctional cyanate resin composition according to claim 1 or 2, wherein the polyfunctional cyanate resin is a cyanate resin derived from bisphenol A.

4. A resin-encapsulated type semiconductor device, wherein a semiconductor element is encapsulated using the polyfunctional cyanate resin composition described in claim 1, 2 or 3.

## Patentansprüche

1. Polyfunktionale Cyanatharzzusammensetzung, die (A) ein polyfunktionales Cyanatharz mit einer Funktionsanzahl von 2 oder mehr oder dessen Vorpolymer, (B) ein Epoxyharz mit einem Erweichungspunkt oder Schmelzpunkt von 75 °C oder mehr und (C) einen Härtungskatalysator als unverzichtbare Komponenten umfasst, die **dadurch gekennzeichnet ist, dass** das Epoxyharz ein Epoxyharz der folgenden allgemeinen Formel (1) ist, 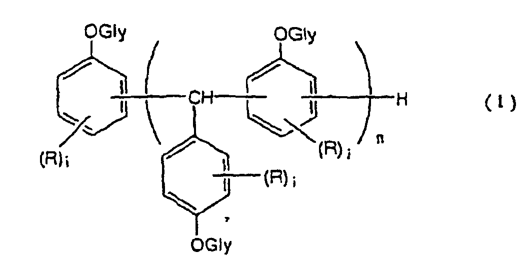 wobei in der Formel n für eine durchschnittliche Wiederholungszahl von 0 - 10 steht; R jeweils unabhängig voneinander für entweder ein Wasserstoffatom, eine Alkylgruppe mit 1 - 10 Kohlenstoffatomen, eine Cycloalkylgruppe mit 5 - 7 Kohlenstoffatomen oder eine Kohlenwasserstoffgruppe, die 6 bis 20 Kohlenstoffatome aufweist, die eine Cycloalkylgruppe mit 5 - 7 Kohlenstoffatomen enthält, steht; das Symbol i jeweils unabhängig voneinander eine ganze Zahl von 1 - 4 ist; wobei, wenn i 2 oder mehr bedeutet, R gleich oder voneinander verschieden sein kann; und Gly für eine Glycidylgruppe steht.

2. Polyfunktionale Cyanatharzzusammensetzung, die die in Anspruch 1 beschriebene polyfunktionale Cyanatharzzusammensetzung und (D) einen anorganischen Füllstoff als unverzichtbare Komponenten umfasst.

3. Polyfunktionale Cyanatharzzusammensetzung nach Anspruch 1 oder 2, wobei das polyfunktionale Cyanatharz ein von Bisphenol A abgeleitetes Cyanatharz ist.

4. Halbleitervorrichtung des harzverkapselten Typs, wobei ein Halbleiterelement unter Verwendung der in den Ansprüchen 1, 2 oder 3 beschriebenen polyfunktionalen Cyanatharzzusammensetzung verkapselt ist.

## Revendications

1. Composition de résine cyanate polyfonctionnelle comprenant (A) une résine cyanate polyfonctionnelle ayant un nombre fonctionnel de 2 ou plus ou son prépolymère, (B) une résine époxy ayant un point de ramollissement ou un point de fusion de 75 °C ou plus, et (C) un catalyseur de durcissement en tant que composants indispensables, **caractérisée en ce que** la résine époxy est une résine époxy représentée par la formule générale suivante (1), 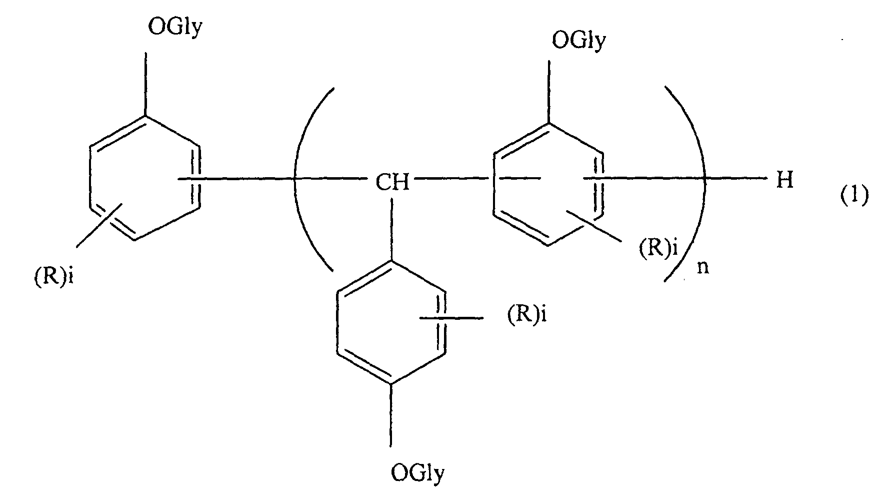 dans la formule, n représente un nombre répétitif moyen de 0 à 10 ; R représente chaque fois indépendamment soit un atome d'hydrogène, soit un groupe alkyle ayant 1 à 10 atomes de carbone, soit un groupe cycloalkyle ayant 5 à 7 atomes de carbone soit un groupe hydrocarbure ayant 6 à 20 atomes de carbone contenant un groupe cycloalcyle ayant 5 à 7 atomes de carbone ; le symbole i est à chaque fois indépendamment un nombre entier relatif de 1 à 4 ; quand i est deux ou plus, les R peuvent être les mêmes, ou ils peuvent être différents l'un de l'autre ; et Gly représente un groupe glycidyle.

2. Composition de résine cyanate polyfonctionnelle comprenant la composition de résine cyanate polyfonctionnelle décrite dans la revendication 1, et (D) une charge inorganique en tant que composants indispensables.

3. Composition de résine cyanate polyfonctionnelle selon la revendication 1 ou 2, dans laquelle la résine cyanate polyfonctionnelle est une résine cyanate dérivée du bisphénol A.

4. Dispositif semi-conducteur du type encapsulé par une résine, dans lequel un élément semi-conducteur est encapsulé en utilisant la composition de résine cyanate polyfonctionnelle décrite dans la revendication 1, 2 ou 3.
